Europäisches Patentamt

European Patent Office

Office européen des brevets

(11) Veröffentlichungsnummer: **0 233 988**
**B1**

(12) # EUROPÄISCHE PATENTSCHRIFT

(45) Veröffentlichungstag der Patentschrift:
13.06.90

(51) Int. Cl.⁵: **G01R 15/02, H01F 40/06**

(21) Anmeldenummer: 86111876.8

(22) Anmeldetag: 27.08.86

(54) **Messwandler zum Messen des in einem elektrischen Leiter fliessenden Stromes.**

(30) Priorität: 10.02.86 CH 518/86

(43) Veröffentlichungstag der Anmeldung:
02.09.87 Patentblatt 87/36

(45) Bekanntmachung des Hinweises auf die Patenterteilung:
13.06.90 Patentblatt 90/24

(84) Benannte Vertragsstaaten:
AT BE CH DE FR GB IT LI NL SE

(56) Entgegenhaltungen:
WO-A-83/01535
DE-B- 1 079 192
DE-B- 1 133 817

IEEE TRANSACTIONS ON POWER APPARATUS AND
SYSTEMS, Band PAS-99, Nr. 3, Mai/Juni 1980,
Seiten 1032-1037, IEEE, New York, US; G.L. JOHNSON:
"Hall effect measurement of real and reactive power in
a Faraday machines laboratory"
ELECTRONIC ENGINEERING, Band 39, Nr. 473,
Juli 1967, Seiten 452-457; D.J. LLOYD et al.: "A
Hall-effect measuring system for large direct and
alternating currents"

(73) Patentinhaber: Landis & Gyr Betriebs AG,
CH-6301 Zug(CH)

(72) Erfinder: Seitz, Thomas, Hasenbühlweg 7,
Ch-6300 Zug(CH)

## Beschreibung

Die Erfindung bezieht sich auf einen Messwandler zum Messen des in einem elektrischen Leiter fliessenden Stromes gemäss dem Oberbegriff des Anspruchs 1.

Derartige Messwandler werden z.B. in Elektrizitätszählern verwendet zur Ermittlung einer an einen Verbraucher abgegebenen Momentanleistung. In diesem Fall wird der Momentanwert eines elektrischen Stromes mit der Anordnung gemessen und anschliessend mit dem Momentanwert einer Versorgungsspannung multipliziert. Die Multiplikation erfolgt dabei in bevorzugter Weise mit Hilfe eines Hallelementes, das zur Strommessung sowieso in der Anordnung vorhanden ist.

Eine Anordnung gemäss dem Oberbegriff des Anspruchs 1 ist aus dem Buch Hallgeneratoren, Eigenschaften und Anwendungen, F. Kuhrt und H.J. Lippmann, Springer Verlag, 1968, Seiten 10 bis 11 und Seiten 267 bis 275 bekannt.

Der Erfindung liegt die Aufgabe zugrunde, einen Messwandler der eingangs genannten Art zu schaffen, dessen Montage ohne Verschlechterung der Linearität und des Phasenfehlers und unter Verbesserung der Luftspalttoleranzen besonders präzis, einfach und zuverlässig ist.

Die genannte Aufgabe wird erfindungsgemäss durch die im Kennzeichen des Anspruchs 1 angegebenen Merkmale gelöst.

Ausführungsbeispiele der Erfindung sind in der Zeichnung dargestellt und werden im folgenden näher beschrieben.

Es zeigen:

Fig. 1 einen ersten Querschnitt A-B des Aufbaus einer ersten Variante eines Messwandlers,
Fig. 2 einen zweiten Querschnitt C-D des Aufbaus der ersten Variante,
Fig. 3 einen Aufbau einer zweiten Variante eines Messwandlers und
Fig. 4 einen Aufbau einer dritten Variante eines Messwandlers.

Gleiche Bezugszahlen bezeichnen in allen Figuren der Zeichnung gleiche Teile.

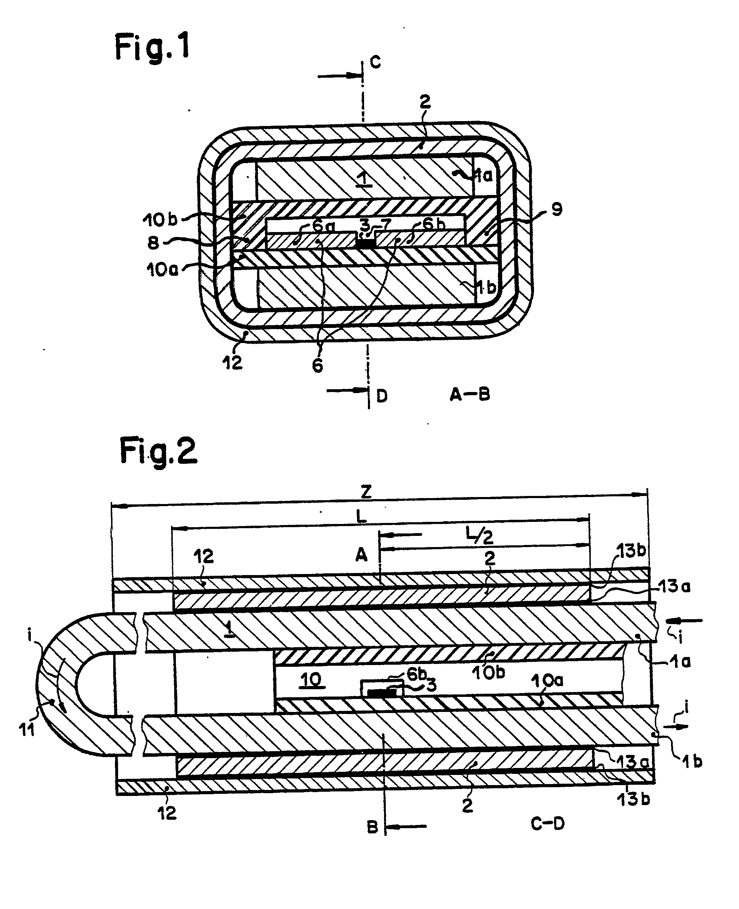

Der in den Figuren 1 und 2 dargestellte Messwandler zum Messen des in einem elektrischen Leiter 1 fliessenden Stromes i enthält einen dreischenkligen ferromagnetischen Kern 2;6 und einen Magnetfeldsensor 3, der vorzugsweise ein Hallelement ist. Der ferromagnetische Kern 2;6 besteht vorzugsweise aus einem Ring 2 und einem Mittelschenkel 6. Die in der Darstellung der Zeichnung obere und untere Fläche des Rings 2 bilden die beiden Aussenschenkel und die beiden seitlichen Flächen des Ringes 2 das Joch des dreischenkligen ferromagnetischen Kerns 2;6, wobei das Joch die drei Schenkel jeweils an ihren beiden Enden miteinander verbindet. Als Material für den ferromagnetischen Kern 2;6 eignet sich wegen der hohen Permeabilität vorzugsweise eine Eisen-Nickel-Legierung, wie z.B. Permenorm, Vacoperm, Trafoperm, Permax, Ultraperm oder Mumetall. Der Mittelschenkel 6 besitzt mindestens drei Luftspalte 7, 8 und 9, wovon der mittlere Luftspalt 7 den Magnetfeldsensor 3 enthält und die beiden äusseren Luftspalte 8 und 9 je an einem der beiden Enden ·des Mittelschenkels 6 angeordnet sind. Die Länge des mittleren Luftspaltes 7 in Längsrichtung des Mittelschenkels 6 gemessen ist annähernd gleich gross wie die in gleicher Richtung gemessene Breite des Magnetfeldsensors 3, so dass sie genau durch diese Breite des Magnetfeldsensors 3 definiert ist. Jeder der beiden äusseren Luftspalte 8 und 9 ist vorzugsweise in Längsrichtung des Mittelschenkels 6 gemessen länger als der mittlere Luftspalt 7. Der Mittelschenkel 6 besteht vorzugsweise aus zwei flachen Blechstreifen 6a und 6b, die zusammen mit dem Magnetfeldsensor 3 in einem Gehäuse 10 aus nichtferromagnetischem Material, mit Vorteil aus Keramik, angeordnet sind. Das Gehäuse 10 besitzt vorzugsweise einen Boden 10a und einen Gehäusedeckel 10b. Der Mittelschenkel 6 und der Magnetfeldsensor 3 sind in vorteilhafter Weise auf einen Träger aus Isoliermaterial angeordnet, auf dem z.B. noch zusätzlich elektronische Bauelemente vorhanden sind, wobei vorzugsweise der Boden 10a des Gehäuses 10 dieser Träger ist. Dies gestattet eine einfache, präzise und zuverlässige Montage des Magnetfeldsensors 3 und des Mittelschenkels 6, die beide zusammen eine Baueinheit bilden, wobei diese beiden Komponenten so in einer anderen Technologie hergestellt werden können als z.B. der restliche Teil des ferromagnetischen Kerns 2;6. Die beiden äusseren Luftspalte 8 und 9 sind durch je eine Wand des Gehäuses 10 ausgefüllt, so dass ihre Luftspaltlängen genau durch die Wanddicke des Gehäuses 10 definiert werden können. Der Ring 2 besteht aus mindestens einem ringförmig gebogenen Blech, was seine Herstellung stark vereinfacht. Die Breite L des Ringes 2 ist grösser als seine grösste Lichtweite, so dass er den Magnetfeldsensor 3 sehr gut gegen die Wirkung äusserer

Fremdmagnetfelder $\vec{H}_a$ abschirmt. Der elektrische Leiter 1 besitzt vorzugsweise einen rechteckförmigen Querschnitt und der Ring 2 ist dann auch in bevorzugter Weise rechteckförmig. Der Mittelschenkel 6 ist mindestens teilweise vom elektrischen Leiter 1 umgeben und vorzugsweise zwischen je einem in der Nähe parallel zueinander verlaufenden Hin- und Rückleiter 1a und 1b des elektrischen Leiters 1 angeordnet. Der elektrische Leiter 1 bildet z.B. eine U-förmige Schleife 11, deren Hin- und Rückleiter die parallel zueinander verlaufenden Hin- und Rückleiter 1a und 1b des elektrischen Leiters 1 sind. Der rechteckförmige Querschnitt des elektrischen Leiters 1 beträgt z.B. 2mm • 10 mm für einen Strom i von 100A. Wird als Magnetfeldsensor 3 z.B. ein Hallelement verwendet, das Magnetfelder misst, die senkrecht zu seiner Oberfläche wirksam sind, dann füllt der Magnetfeldsensor 3 z.B. den Luftspalt 7 vollständig aus. Wird dagegen ein Hallelement verwendet, das Magnetfelder misst, die parallel zu seiner Oberfläche wirksam sind, dann füllt der Magnetfeldsensor 3 z.B. nur die untere Hälfte (siehe Fig. 1) des Luftspaltes 7 aus. Die Länge des Luftspaltes 7 beträgt z.B. 0,6 mm und diejenige der weiteren Luftspalte 8 und 9 z.B. je 1,7 mm. Auf dem Träger können innerhalb oder ausserhalb des Gehäuses 10a; 10b noch zusätzlich elektronische, nicht dargestellte Bauelemente angeordnet sein, die z.B. Teil der Beschaltungselektronik des Magnetfeldsensors 3 sind.

In der Fig. 1 wurde angenommen, dass die Breite des Gehäuses 10 grösser ist als die Breite des elektrischen Leiters 1. In diesem Fall füllt im Querschnitt A-B das Gehäuse 10 z.B. den Raum zwischen dem Hin- und Rückleiter 1a und 1b der Schleife 11 vollständig aus. Die Breite des Gehäuses 10 kann auch gleich oder kleiner sein als die Breite des elektrischen Leiters 1. Im letzten Fall füllt im Querschnitt A-B das Gehäuse 10 den Raum zwischen dem Hin- und Rückleiter 1a und 1b der Schleife 11 nur teilweise aus. In allen Fällen umgibt der Ring 2 der Breite L den Hin- und Rückleiter 1a und 1b der Schleife 11 sowie das Gehäuse 10 derart, dass der Mittelschenkel 6, parallel zu seiner Querrichtung gemessen, annähernd in der Mitte auf halber Entfernung L/2 vom Rand des Ringes 2 angeordnet ist (siehe Fig. 2). Der Hin- und der Rückleiter 1a und 1b der Schleife 11 durchqueren den Hohlraum zwischen dem Gehäuse 10 und dem Ring 2 z.B. derart, dass sie nach Möglichkeit sowohl räumlichen Kontakt mit dem Gehäuse 10a;10b als auch elektrisch isolierten räumlichen Kontakt mit dem Ring 2 besitzen. Zwischen dem Ring 2 einerseits und dem Hin- und Rückleiter 1a und 1b der Schleife 11 anderseits ist somit eine Isolationsschicht 13a vorhanden (siehe Fig. 1 und Fig. 2).

Der Ring 2 ist vorteilhaft auf seiner Mantelfläche vollständig von einer annähernd parallelen ringförmigen und breiteren Aussenabschirmung 12 umgeben. Zwischen dem Ring 2 und der Aussenabschirmung 12 befindet sich z.B. eine Isolierschicht 13b. Die Aussenabschirmung 12 hat eine Breite Z, die grösser ist als die Breite L des Ringes 2, damit dessen stirnseitige Flächen noch teilweise mit abgeschirmt werden. Die Breite Z beträgt z.B. 30 mm. Die Aussenabschirmung 12 besteht vorteilhaft aus Tiefziehstahl oder aus einer Eisen-Nickel-Legierung. Die Isolierschicht 13b zwischen Ring 2 und Aussenabschirmung 12 dient hier auch dazu, den räumlichen Abstand zwischen den beiden zu vergrössern, was die Schirmwirkung der Aussenabschirmung 12 verbessert. Dieser räumliche Abstand beträgt z.B. 0,05 mm. Die Aufgabe der Aussenabschirmung 12 ist es, den hochpermeablen, aber leicht sättigenden Ring 2, der ja auch als Schirm wirksam ist, bei starken äusseren Fremdmagnetfeldern $\vec{H}_a$ zu entlasten. Der Ring 2 und die Aussenabschirmung 12 wirken somit als Doppelschirm. Ohne Aussenabschirmung 12 bleibt der durch den Ring 2 gebildete Schirm ungesättigt bis zu einem Wert des äusseren Fremdmagnetfeldes $\vec{H}_a$ von etwa 50A/cm. Beim Vorhandensein des Doppelschirms dagegen bleibt der durch den Ring 2 gebildete Schirm ungesättigt bis zu einem Wert des äusseren Fremdmagnetfeldes $\vec{H}_a$ von etwa 200A/cm.

Bei Verwendung einer Eisen-Nickel Legierung für den Kern 2;6 ist der magnetische Spannungsabfall am ferromagnetischen Material im Vergleich mit demjenigen am Luftspalt 7 bzw. an den Luftspalten 7, 8 und 9 vernachlässigbar. Dementsprechend wirken sich auch Nichtlinearität, Phasenfehler und Temperaturkoeffizient des hochpermeablen Materials nur geringfügig auf den Messwandler aus. Die Anordnung des Mittelschenkels 6 und des Magnetfeldsensors 3 auf einem Träger und/oder in einem Gehäuse 10 erlaubt eine besonders präzise, einfache und zuverlässige Montage des Messwandlers. Die Verwendung von drei Luftspalten 7, 8 und 9 gestattet es, alle Toleranzprobleme der Luftspaltlänge in den beiden äusseren Luftspalte 8 und 9 zu konzentrieren, wo sie am wenigsten stören, da dort die Magnetflusslinien nicht mehr parallel und dicht gepackt sind, sondern bereits teilweise auseinanderlaufen und ihren Weg durch den am ferromagnetischen Kern 2 angrenzenden Luftraum suchen. Diese Toleranzprobleme sind um so geringer, je stärker das Auseinanderlaufen der Magnetflusslinien ist, d.h. je länger die äusseren Luftspalte 8 und 9 sind.

Die zweite und dritte Variante unterscheiden sich von der ersten Variante nur durch die Formgebung des elektrischen Leiters 1.

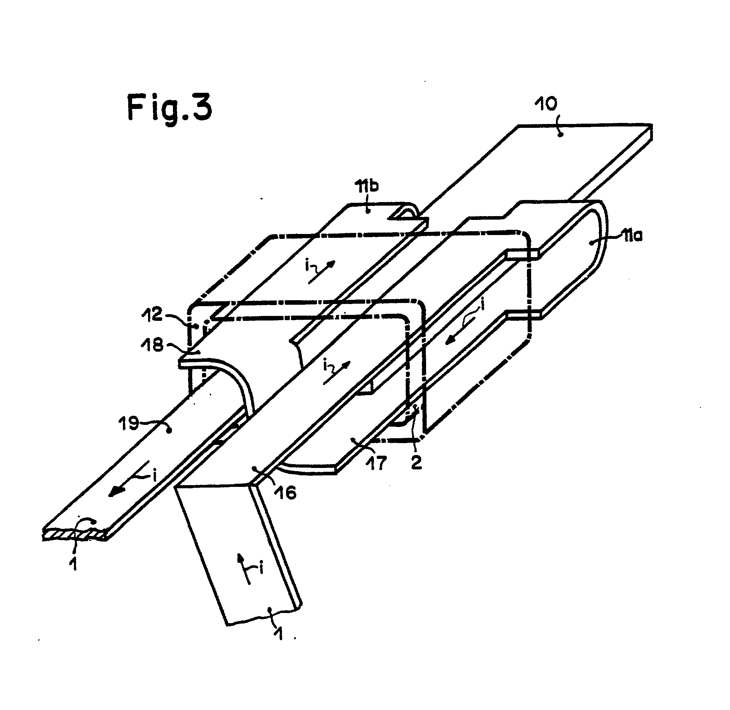

In der in der Fig. 3 dargestellten Anordnung bildet der elektrische Leiter 1 mindestens zwei U-förmige Schleifen 11a and 11b, die seitlich parallel nebeneinander angeordnet und elektrisch in Reihe geschaltet sind. Dabei sind beide Leiter 16 und 17 bzw. 18 und 19 einer jeden Schleife 11a bzw. 11b parallel deckend übereinander angeordnet. Die beiden Hinleiter 16 und 18 einerseits und die beiden Rückleiter 17 und 19 anderseits der beiden Schleifen 11a und 11b sind jeweils in einer gleichen Ebene nebeneinander angeordnet. Das Gehäuse 10 und damit auch der Mittelschenkel 6 mit dem Magnetfeldsensor 3 sind zwischen den beiden Hinleitern 16 und 18 einerseits und den beiden Rückleitern 17 und 19 anderseits angeordnet, wobei alle diese Hin- und Rückleiter in der Nähe des Gehäuses 10 verlaufen. Der Ring 2 und, falls vorhanden, die Aussenabschirmung 12 umgeben seitlich und von ihnen elektrisch isoliert die beiden U-förmigen Schleifen 11a und 11b. Die Anordnung ermöglicht es, ohne die Konfigurationen des Kerns 2 und des Gehäuses 10 zu ändern, den Kern 2 mit halbem Strom, z.B. mit 50A, zu erregen. Dieser halbe Strom erzeugt mit zwei Schleifen 11a und 11b ein gleich grosses Magnetfeld $\vec{H}$ wie der Strom i mit einer einzigen Schleife 11.

Selbstverständlich können die U-förmigen Schleifen 11a und 11b auch deckend ineinander geschoben angeordnet sein. In diesem Fall sind die beiden Hinleiter 16 und 18 einerseits und die beiden Rückleiter 17 und 19 anderseits deckend übereinander statt nebeneinander angeordnet. Die Hin- und Rückleiter 16 bis 19 können dann annähernd doppelt so breit und halb so dick sein.

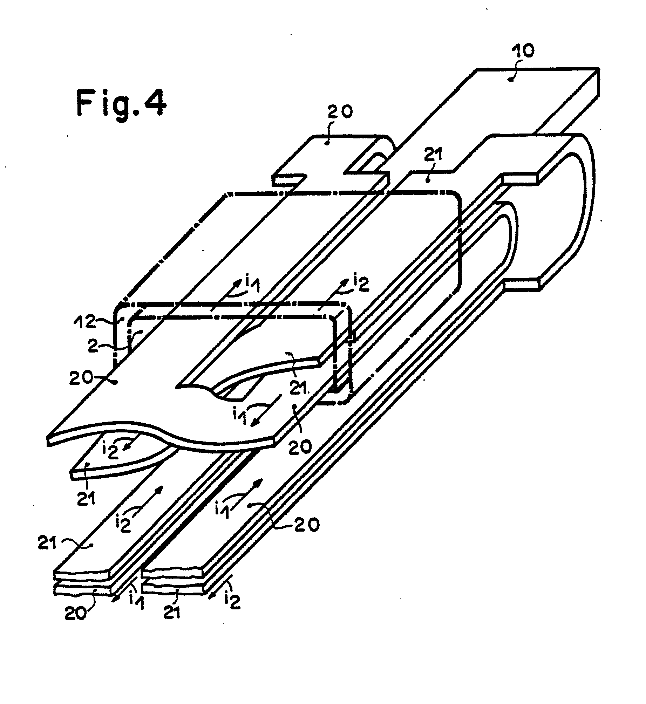

Bei der in der Fig. 4 dargestellten dritten Variante besteht der elektrische Leiter 1 aus zwei Leitern 20 und 21, die mindestens innerhalb des Ringes 2 parallel sind und die mindestens einmal derart angeordnet sind, dass sie den Ring 2 zuerst in der einen Richtung durchqueren, sich elektrisch isoliert kreuzen um anschliessend den Ring 2 in umgekehrter Richtung erneut zu durchqueren. Dabei ist das Gehäuse 10 und damit auch der Mittelschenkel 6 jeweils für beide Richtungen zwischen den beiden Leitern 20 und 21 angeordnet. Die beiden Leiter 20 und 21 sind z.B. parallel deckend überein angeordnet. Eine Aussenabschirmung 12 umgibt auch hier in vorteilhafter Weise den Ring 2 seitlich. Diese Anordnung wird z.B. in Elektrizitätszählern der USA verwendet und ermöglicht es, ohne die Konfigurationen des Gehäuses 10 und des ferromagnetischen Kerns 2;6 zu ändern, den Kern 2;6 mit zwei unabhängigen einphasigen Strömen $i_1$ und $i_2$ von z.B. je 200A zu erregen, wobei im Extremfall einer der beiden Ströme $i_1$ bzw. $i_2$ Null sein kann. Ein derartiger Gesamtaufbau der Leiter 20 und 21 gestattet es, die Uebertragungskonstanten der beiden Ströme $i_1$ und $i_2$ genau gleich gross zu machen.

## Patentansprüche

1. Messwandler zum Messen des in einem elektrischen Leiter (1) fliessenden Stromes (i), mit einem dreischenkligen ferromagnetischen Kern (2;6), dessen Mittelschenkel (6) mindestens teilweise vom elektrischen Leiter (1) umgeben ist und der mindestens einen Luftspalt (7) enthält, in dem ein Magnetfeldsensor (3) angeordnet ist, dadurch gekennzeichnet, dass der Mittelschenkel (6) drei Luftspalte (7, 8, 9) besitzt, von denen der mittlere den Magnetfeldsensor (3) enthält und die beiden äusseren je an einem der beiden Enden des Mittelschenkels (6) angeordnet sind, dass der Mittelschenkel (6) und der Magnetfeldsensor (3) zusammen eine Baueinheit bilden, und dass jeder der beiden äusseren Luftspalte (8, 9) in der Längsrichtung des Mittelschenkels (6) gemessen länger ist als der mittlere Luftspalt (7).

2. Messwandler nach Anspruch 1, dadurch gekennzeichnet, dass der Mittelschenkel (6) aus zwei flachen Blechstreifen (6a, 6b) besteht, die zusammen mit dem Magnetfeldsensor (3) in einem Gehäuse (10) aus nichtferromagnetischem Material angeordnet sind, und dass die beiden äusseren Luftspalte (8, 9) durch je eine Wand des Gehäuses (10) ausgefüllt sind.

3. Messwandler nach Anspruch 1 oder 2, dadurch gekennzeichnet, dass das Joch und die beiden Aussenschenkel des ferromagnetischen Kerns (2;6) durch einen Ring (2) gebildet sind, der aus mindestens einem ringförmig gebogenen Blech besteht.

4. Messwandler nach Anspruch 3, dadurch gekennzeichnet, dass die Breite (L) des Ringes (2) grösser ist als seine grösste Lichtweite.

5. Messwandler nach einem der Ansprüche 1 bis 4, dadurch gekennzeichnet, dass die Länge des mittleren Luftspaltes (7) in Längsrichtung des Mittelschenkels (6) gemessen annähernd gleich gross ist wie die in gleicher Richtung gemessene Breite des Magnetfeldsensors (3).

6. Messwandler nach einem der Ansprüche 3 bis 5, dadurch gekennzeichnet, dass der elektrische Leiter (1) einen rechteckförmigen Querschnitt besitzt und dass der Ring (2) rechteckförmig ist.

7. Messwandler nach einem der Ansprüche 1 bis 6, dadurch gekennzeichnet, dass der Mittelschenkel (6) zwischen je einem in der Nähe parallel zueinander verlaufenden Hin- und Rückleiter (1a, 1b) des elektrischen Leiters (1) angeordnet ist.

8. Messwandler nach Anspruch 7, dadurch gekennzeichnet, dass der elektrische Leiter (1) eine U-förmige Schleife (11) bildet und dass deren Hin- und Rückleiter die parallel zueinander verlaufenden Hin- und Rückleiter (1a, 1b) des elektrischen Leiters (1) sind.

9. Messwandler nach einem der Ansprüche 1 bis 7, dadurch gekennzeichnet, dass der elektrische Leiter (1) mindestens zwei U-förmige Schleifen (11a, 11b) bildet, die seitlich parallel nebeneinander angeordnet und elektrisch in Reihe geschaltet sind, wobei beide Leiter (16, 17 bzw. 18, 19) einer jeden Schleife (11a bzw. 11b) parallel deckend übereinander und die beiden Hinleiter (16, 18) einerseits und die beiden Rückleiter (17, 19) anderseits der beiden Schleifen (11a, 11b) jeweils in einer gleichen Ebene nebeneinander angeordnet sind, und dass der Mittelschenkel (6) mit dem Magnetfeldsensor (3) zwischen den beiden Hinleitern (16, 18) einerseits und den beiden Rückleitern (17, 19) anderseits angeordnet sind.

10. Messwandler nach einem der Ansprüche 1 bis 7, dadurch gekennzeichnet, dass der elektrische Leiter (1) mindestens zwei U-förmige Schleifen (11a, 11b) bildet, die deckend ineinander geschoben angeordnet und elektrisch in Reihe geschaltet sind, wobei die Leiter (16, 17, 18, 19) aller Schleifen (11a, 11b) parallel deckend übereinander angeordnet sind, und dass der Mittelschenkel (6) mit dem Magnetfeldsensor (3) zwischen den beiden Hinleitern (16, 18) einerseits und den beiden Rückleitern (17, 19) anderseits angeordnet sind.

11. Messwandler nach einem der Ansprüche 3 bis 7, dadurch gekennzeichnet, dass der elektrische Leiter (1) mindestens innerhalb des Ringes (2) aus zwei parallelen Leitern (20, 21) besteht, die mindestens einmal derart angeordnet sind, dass sie den Ring (2) zuerst in einer Richtung durchqueren, sich dann elektrisch isoliert kreuzen um anschliessend den Ring (2) in umgekehrter Richtung erneut zu durchqueren, wobei der Mittelschenkel (6) jeweils für beide Richtungen zwischen den beiden Leitern (20, 21) angeordnet ist.

12. Messwandler nach einem der Ansprüche 2 bis 11, dadurch gekennzeichnet, dass der Mittelschenkel (6) und der Magnetfeldsensor (3) auf einem Träger aus Isoliermaterial angeordnet sind.

13. Messwandler nach Anspruch 12, dadurch gekennzeichnet, dass der Träger ein Boden (10a) des Gehäuses (10) ist.

14. Messwandler nach Anspruch 13, dadurch gekennzeichnet, dass das Gehäuse (10) aus Keramik besteht.

15. Messwandler nach einem der Ansprüche 12 bis 14, dadurch gekennzeichnet, dass auf dem Träger noch zusätzlich elektronische Bauelemente angeordnet sind.

16. Messwandler nach einem der Ansprüche 1 bis 15, dadurch gekennzeichnet, dass der ferromagnetische Kern (2;6) aus einer Eisen-Nickel-Legierung besteht.

17. Messwandler nach einem der Ansprüche 3 bis 16, dadurch gekennzeichnet, dass der Ring (2) auf seiner Mantelfläche von einer annähernd parallelen, ringförmigen und breiteren Aussenabschirmung (12) umgeben ist.

18. Messwandler nach Anspruch 17, dadurch gekennzeichnet, dass die Aussenabschirmung (12) aus Tiefziehstahl besteht.

19. Messwandler nach Anspruch 17, dadurch gekennzeichnet, dass die Aussenabschirmung (12) aus einer Eisen-Nickel-Legierung besteht.

20. Messwandler nach einem der Ansprüche 17 bis 19, dadurch gekennzeichnet, dass zwischen dem Ring (2) und der Aussenabschirmung (12) ein räumlicher Abstand besteht.

## Claims

1. A measuring transformer for measuring the current (i) flowing in an electrical conductor (1), comprising a three-limb ferromagnetic core (2; 6), the central limb (6) of which is at least partially surrounded by the electrical conductor (1) and which includes at least one air gap (7) in which a magnetic field sensor (3) is arranged, characterised in that the central limb (6) has three air gaps (7, 8, 9) of which the central air gap contains the magnetic field sensor (3) and the two outer air gaps are each arranged at respective ones of the two ends of the central limb (6), that the central limb (6) and the magnetic field sensor (3) together form a structural unit, and that each of the two outer air gaps (8, 9), as measured in the longitudinal direction of the central limb (6), is longer than the central air gap (7).

2. A measuring transformer according to claim 1 characterised in that the central limb comprises two flat sheet metal strips (6a, 6b) which together with the magnetic field sensor (3), are disposed in a housing (10) of non-ferromagnetic material, and that the two outer air gaps (8, 9) are filled by a respective wall of the housing (10).

3. A measuring transformer according to claim 1 or claim 2 characterised in that the yoke and the two outer limbs of the ferromagnetic core (2; 6) are formed by a ring (2) which comprises at least one sheet metal portion which is bent in an annular configuration.

4. A measuring transformer according to claim 3 characterised in that the width (L) of the ring (2) is greater than its greatest internal width.

5. A measuring transformer according to one of claims 1 to 4 characterised in that the length of the central air gap (7), as measured in the longitudinal direction of the central limb (6), is approximately the same as the width of the magnetic field sensor (3) which is measured in the same direction.

6. A measuring transformer according to one of claims 3 to 5 characterised in that the electrical conductor (1) is of a rectangular cross-section and that the ring (2) is rectangular.

7. A measuring transformer according to one of claims 1 to 6 characterised in that the central limb (6) is arranged between respective out-and-back conductors (1a, 1b) of the electrical conductor (1) which extend adjacent and parallel to each other.

8. A measuring transformer according to claim 7 characterised in that the electrical conductor (1) forms a U-shaped loop (11) and that the out-and-back conductors thereof are the mutually parallel out-and-back conductors (1a, 1b) of the elctrical conductor (1).

9. A measuring transformer according to one of claims 1 to 7 characterised in that the electrical conductor (1) forms at least two U-shaped loops (11a, 11b) which are arranged laterally parallel in side-by-side relationship and are electrically connected in series, wherein the two conductors (16, 17 and 18, 19 respectively) of each loop (11a, 11b respectively) are arranged parallel one above the other in aligned relationship and the two out conductors (16, 18) on the one hand and the two back conductors (17, 19) on the other hand of the two loops (11a, 11b) are respectively arranged in the same plane in side-by-side relationship, and that the central limb (6) with the magnetic field sensor (3) are arranged between the two out conductors (16, 18) on the one hand and the two back conductors (17, 19) on the other hand.

10. A measuring transformer according to one of claims 1 to 7 characterised in that the electrical conductor (1) forms at least two U-shaped loops (11a, 11b) which are arranged in such a way as to be pushed one into the other in aligned relationship and are electrically connected in series, wherein the conductors (16, 17, 18, 19) of all loops (11a, 11b) are arranged parallel one above the other in aligned relationship, and that the central limb (6) with the magnetic field sensor (3) are arranged between the two out conductors (16, 18) on the one hand and the two back conductors (17, 19) on the other hand.

11. A measuring transformer according to one of claims 3 to 7 characterised in that at least within the ring (2) the electrical conductor (1) comprises two parallel conductors (20, 21) which at least once are arranged in such a way that they first pass through the ring (2) in one direction, then cross each other in an electrically insulated condition in order then again to pass through the ring (2) in the reverse direction, wherein the central limb (6) is arranged between the two conductors (20, 21) for each of the two directions.

12. A measuring transformer according to one of claims 2 to 11 characterised in that the central limb (6) and the magnetic field sensor (3) are arranged on a carrier of insulating material.

13. A measuring transformer according to claim 12 characterised in that the carrier is a bottom (10a) of the housing (10).

14. A measuring transformer according to claim 13 characterised in that the housing (10) comprises ceramic.

15. A measuring transformer according to one of claims 12 to 14 characterised in that electronic components are also additionally disposed on the carrier.

16. A measuring transformer according to one of claims 1 to 15 characterised in that the ferromagnetic core (2; 6) comprises an iron-nickel alloy.

17. A measuring transformer according to one of claims 3 to 16 characterised in that the ring (2) is surrounded on its peripheral surface by an approximately parallel, annular and wider outer screening (12).

18. A measuring transformer according to claim 17 characterised in that the outer screening (12) comprises deep-drawing steel.

19. A measuring transformer according to claim 17 characterised in that the outer screening (12) comprises an iron-nickel alloy.

20. A measuring transformer according to one of claims 17 to 19 characterised in that there is a three-dimensional spacing between the ring (2) and the outer screening (12).

## Revendications

1. Transformateur de mesure pour la mesure du courant (i) circulant dans un conducteur électrique (1), comportant un noyau ferromagnétique (2; 6) à trois branches, dont la branche médiane (6) est entourée au moins partiellement par le conducteur électrique (1) et qui contient au moins un entrefer (7), dans lequel est disposé une sonde magnétique (3), caractérisé en ce que la branche médiane (6) possède trois entrefers (7, 8, 9), parmi lesquels l'entrefer médian contient la sonde magnétique (3) et les entrefers extérieurs sont disposés chacun sur l'une des deux extrémités de la branche médiane (6), que la branche médiane (6) et la sonde magnétique (3) forment ensemble une unité de construction et que chacun des deux entrefers extérieurs (8, 9) est plus long que l'entrefer médian (7), dans la direction longitudinale de la branche médiane (6).

2. Transformateur de mesure selon la revendication 1, caractérisée en ce que la branche médiane (6) est constituée de deux bandes de tôle plates (6a, 6b), qui sont disposées, conjointement avec la sonde magnétique (3), dans un boîtier (10) réalisé en un matériau non ferromagnétique, et que les deux entrefers extérieurs (8, 9) sont remplis respectivement par une paroi du boîtier (10).

3. Transformateur de mesure selon la revendication 1 ou 2, caractérisé en ce que la culasse et les deux branches extérieures du noyau ferromagnétique (2; 6) sont formées par un anneau (2) constitué par au moins une tôle annulaire repliée.

4. Transformateur de mesure selon la revendication 3, caractérisé en ce que la largeur (L) de l'anneau (2) est supérieure à son diamètre maximum.

5. Transformateur de mesure selon l'une des revendications 1 à 4, caractérisé en ce que la longueur de l'entrefer médian (7), mesurée dans la direction longitudinale de la branche médiane (6), est approximativement égale à la largeur, mesurée dans la même direction, de la sonde magnétique (3).

6. Transformateur de mesure selon l'une des revendications 3 à 5, caractérisé en ce que le conducteur électrique (1) possède une section transversale rectangulaire et que l'anneau (2) est rectangulaire.

7. Transformateur de mesure selon l'une des revendications 1 à 6, caractérisé en ce que la branche médiane (6) est disposée entre respectivement un conducteur aller et un conducteur retour (1a, 1b), qui sont approximativement parallèles entre eux, du conducteur électrique (1).

8. Transformateur de mesure selon la revendication 7, caractérisé en ce que le conducteur électrique (1) forme une boucle (11) en forme de U et que les conducteurs aller et retour de cette boucle sont les conducteurs aller et retour (1a, 1b), parallèles entre eux, du conducteur électrique (1).

9. Transformateur de mesure selon l'une des revendications 1 à 7, caractérisé en ce que le conducteur électrique (1) forme au moins deux boucles (11a, 11b) en forme de U, qui sont disposées côte-à-côte en étant parallèles entre elles et sont branchées électriquement en série, les deux conducteurs (16, 17 ou 18, 19) de chaque boucle (11a ou 11b) étant disposés en recouvrement réciproque, parallèlement l'un à l'autre, que les deux conducteurs aller (16, 18) d'une part et les deux conducteurs retour (17, 19) d'autre part des deux boucles (11a, 11b) sont disposés respectivement côte-à-côte dans un même plan, et que la branche médiane (6) comportant la sonde magnétique (3) est disposée entre les deux conducteurs aller (16, 18) d'une part et les deux conducteurs retour (17, 19) d'autre part.

10. Transformateur de mesure selon l'une des revendications 1 à 7, caractérisé en ce que le conducteur électrique (1) forme au moins deux boucles (11a, 11b) en forme de U, qui sont insérées l'une dans l'autre en recouvrement et sont branchées électriquement en série, de sorte que les conducteurs (16, 17, 18, 19) de toutes les boucles (11a, 11b) soient disposés en recouvrement réciproque parallèlement, et en ce que la branche médiane (6) comportant la sonde magnétique (3) soit disposée entre les deux conducteurs aller (16, 18) d'une part et les deux conducteurs retour (17, 19) d'autre part.

11. Transformateur de mesure selon l'une des revendications 3 à 7, caractérisé en ce que le conducteur électrique (1) est constitué, au moins à l'intérieur de l'anneau (2), par deux conducteurs parallèles (20, 21), qui sont disposés au moins de telle sorte qu'ils traversent l'anneau (2) tout d'abord dans un sens, se croisent en étant isolés électriquement pour ensuite traverser à nouveau l'anneau (2) dans le sens opposé, la branche médiane (6) étant disposée entre les deux conducteurs (20, 21), respectivement dans les deux sens.

12. Transformateur de mesure de mesure selon l'une des revendications 2 à 11, caractérisé en ce que la branche médiane (6) et la sonde magnétique (3) sont disposées sur un support réalisé en un matériau isolant.

13. Transformateur de mesure selon la revendication 12, caractérisé en ce que le support est un fond (10a) du boîtier (10).

14. Transformateur de mesure selon la revendication 13, caractérisé en ce que le boîtier (12) est formé d'une céramique.

15. Transformateur de mesure selon l'une des revendications 12 à 14, caractérisé en ce que des composants électroniques sont en outre disposés en supplément sur le support.

16. Transformateur de mesure selon l'une des revendications 1 à 15, caractérisé en ce que le noyau ferromagnétique (2; 6) est réalisé en un alliage fer-nickel.

17. Transformateur de mesure selon l'une des revendications 3 à 16, caractérisé en ce que l'anneau (2) est entouré, sur sa surface enveloppe, par un blindage extérieur (12) approximativement parallèle, de forme annulaire et plus large.

18. Transformateur de mesure selon la revendication 17, caractérisé en ce que le blindage extérieur (12) est réalisé en acier embouti.

19. Transformateur de mesure selon la revendication 17, caractérisé en ce que le blindage extérieur (12) est réalisé en un alliage fer-nickel.

20. Transformateur de mesure selon les revendications 17 à 19, caractérisé en ce qu'il existe une séparation spatiale entre l'anneau (2) et le blindage extérieur (12).

# Fig.1

# Fig.2

# Fig.3

Fig.4